(19) Europäisches Patentamt / European Patent Office / Office européen des brevets

(11) **EP 2 562 784 B1**

(12) **EUROPÄISCHE PATENTSCHRIFT**

(45) Veröffentlichungstag und Bekanntmachung des Hinweises auf die Patenterteilung:
**13.01.2016 Patentblatt 2016/02**

(51) Int Cl.:
*H05H 1/00* (2006.01)    *H01J 37/32* (2006.01)
*G01B 7/06* (2006.01)

(21) Anmeldenummer: **12005982.9**

(22) Anmeldetag: **22.08.2012**

(54) **Sensoranordnung zur Charakterisierung von Plasmabeschichtungs-, Plasmaätz- und Plasmabehandlungsprozessen sowie Verfahren zur Ermittlung von Kenngrößen in diesen Prozessen**

Sensor assembly for characterization of plasma coating, plasma etching and plasma treatment processes and method for determining characteristic parameters in these processes

Agencement de capteur destiné à caractériser les processus de revêtement par plasma, gravure par plasma et traitement plasma ainsi que le procédé de détermination de grandeurs de référence dans ces processus

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.08.2011 DE 102011111613**

(43) Veröffentlichungstag der Anmeldung:
**27.02.2013 Patentblatt 2013/09**

(73) Patentinhaber: **Helmholtz-Zentrum Berlin für Materialien und Energie GmbH**
**14109 Berlin (DE)**

(72) Erfinder:
• **Ellmer, Klaus**
  **DE-12683 Berlin (DE)**
• **Harbauer, Karsten**
  **DE-14469 Potsdam (DE)**

(56) Entgegenhaltungen:
**US-A- 5 885 402    US-A1- 2005 034 811**

• **KARSTEN HARBAUER: "Aufbau und Inbetriebnahme eines Kombinationssensors zur kombinierten Plasma- und Schichtcharakterisierung während des Magnetronsputterns", DIPLOMARBEIT TECHNISCHE FACHHOCHSCHULE WILDAU, 10. Januar 2005 (2005-01-10), Seiten 17-44, XP055118603,**
• **KARSTEN HARBAUER ET AL: "A combined sensor for the diagnostics of plasma and film properties in magnetron sputtering processes", THIN SOLID FILMS, ELSEVIER-SEQUOIA S.A. LAUSANNE, CH, Bd. 520, Nr. 20, 14. Juni 2012 (2012-06-14), Seiten 6429-6433, XP028427373, ISSN: 0040-6090, DOI: 10.1016/J.TSF.2012.06.053 [gefunden am 2012-06-21]**

**Beschreibung**

Die Erfindung betrifft eine Sensoranordnung zur Charakterisierung von Plasmabeschichtungs-, Plasmaätz- und Plasmabehandlungsprozessen sowie ein Verfahren zur Ermittlung von Kenngrößen in diesen Prozessen. Bei einem Plasmabehandlungsprozess wird ein Plasma benutzt, um eine Oberfläche zu funktionalisieren oder zu aktivieren. Damit werden die Eigenschaften der behandelten Oberfläche in einer Tiefe von ein bis zwei Monolagen beeinflusst.

Plasmabeschichtungs- und Plasmaätzprozesse werden dem Stand der Technik nach charakterisiert, indem nacheinander die Beschichtungs- oder Ätzrate mittels eines Schwingquarz-Schichtdickenmonitors (s. beispielsweise Applications of Piezoelectric Quartz Crystal Microbalances, Elsevier, Amsterdam, 1984, pp. 221), die Plasmadichte mittels einer zylindrischen oder planaren Langmuirsonde (z. B. beschrieben in Plasma Diagnostics, Academic Press, Boston, 1989, pp.113) und der totale Energieeintrag mittels einer kalorimetrischen Sonde (J. Vac. Sci. Techn. 15/2 (1978) 188 und Rev. Sci. Instr. 10 (2010) 023504) gemessen werden.

In US 2005/034811 A1 wird die Anwendung eines planaren Langmuir-Sondenarrays zur Plasmacharakterisierung beschrieben.

In US 5 885 402 A ist eine Diagnoseanordnung zur Bestimmung von Plasmaparametern mittels einem Schwingquarz, einem optischen Endpunktdetektor und einer Langmuir-Sonde offenbart.

In der Veröffentlichung Rev. Sci. Instr. 68 (1997) 4555 wurde eine Kombination aus einem Schwingquartz-Schichtdickenmonitor und einem Gegenfeldanalysator beschrieben, um die Beschichtungsrate durch Neutralteilchen und durch Ionen voneinander zu trennen. Über den Einsatz eines speziellen Schwingquarzes für die Untersuchung der Sputterrate von dünnen Schichten durch niederenergetische Ionen ($E_i < 500$ eV) wurde in Rev. Sci. Instr. 70 (1999) 3696 berichtet.

Die nach den beschriebenen Methoden erfolgten Messungen sind meistens zeitaufwändig, weshalb oftmals nur eine dieser Methoden verwendet wurde.

Noch aufwändigere Methoden - wie die laserinduzierte Fluoreszenzspektroskopie (LIF), beschrieben in J. Vac. Sci.Techn. A 8 (1990) 3920, oder die Aktinometrie - werden ausschließlich in der Forschung eingesetzt.

Beim Anmelder wurden in den letzten 20 Jahren Arbeiten zur Charakterisierung von Plasmabeschichtungsprozessen, speziell von Magnetronentladungen, kontinuierlich durchgeführt. Mittels eines Plasmaprozessmonitors (PPM) - einer Kombination aus Massenspektrometer und Energieanalysator - wurden Spezies und deren Energien am Substratort gemessen, wie in Surf. Coat. Techn. 74/75 (1995) 586 und Thin Solid Films 517 (2009) 3143 beschrieben. Die Abhängigkeit der Schichtdicken von gesputterten Metallen, Oxiden und Nitriden von der Entladungsleistung wurde mittels eines Schwingquarz-Schichtdickenmonitors gemessen (s. Thin Films/11th Conf. On High Vacuum, Interfaces and Thin Films, DGM Informationsgesellschaft mbH, Oberursel, Dresden, March, 1994, pp.131 und Surf.Coat. techn. 116-119 (1999) 1102). Für die Abscheidung von Zinkoxid wurden bereits Messungen mit einem PPM, mit einer Langmuir-Sonde und einer Thermosonde nach Thornton kombiniert, die nacheinander ausgeführt werden mussten (J. Appl. Phys. 82/5 (1997) 2115). Ziel war hierbei die Quantifizierung der verschiedenen Teilchen-Flüsse aus dem Plasma und vom Target auf eine wachsende ZnO-Schicht. Der aus anderen technischen Bereichen bekannte Gardon-Sensor wurde zur Energiestrom-Messung eingesetzt, um verschiedene Magnetronsputterquellen hinsichtlich ihres Energieeintrags zu charakterisieren (K. Ellmer, R. Mientus, Surf. Coat. Techn. 116-119 (1999) 1102).

Der Stand der Technik, von dem die Erfindung ausgeht, ist in der Diplomarbeit von K. Harbauer (FB Physikalische Technik, Techn. Fachhochschule Wildau, 2005) beschrieben. Es handelt sich um einen Kombinationssensor, der unter anwendungsnahen Bedingungen Magnetronsputterquellen hinsichtlich Abscheiderate, Energieeinstrom und Plasmaparameter quantifizieren soll. Dieser noch wenig kompakte Sensor vereint in einem gekühlten Metallblock fünf verschiedene Einzeldetektoren wie Schwingquarz, Langmuir-Sonde, Gardonsensor, Biegebalkensensor und Schichtwiderstandssensor.

Aufgabe der Erfindung ist es, eine Sensoranordnung anzugeben, deren Aufbau weniger aufwändig im Vergleich zum Stand der Technik ist und die es gestattet, simultan mehrere Messgrößen zu erfassen. Die Sensoranordnung soll eine im Vergleich zum Stand der Technik schnellere und exaktere Charakterisierung technologischer Plasmaprozesse beispielsweise zur Herstellung dünner Schichten in der Mikroelektronik, der Optik, bei der Hartstoffbeschichtung, in der Photovoltaik oder bei der Architekturglasbeschichtung ermöglichen. Ein Verfahren zur Messung von Parametern zur Charakterisierung der genannten Plasmaprozesse soll ebenfalls angegeben werden.

Die Aufgabe wird durch eine Anordnung der eingangs genannten Art dadurch gelöst, dass erfindungsgemäß die dem Plasmaätz-, Plasmabeschichtungs- oder Plasmabehandlungsprozess ausgesetzte Frontelektrode eines Schwingquarzes isoliert gegen ein Sensorgehäuse der Anordnung und als planare Langmuir-Sonde ausgebildet und mit einem außerhalb der Plasmaanlage angeordneten Strom-Spannungs-Kennlinien-Messgerät zur Messung der Langmuir-Sonden-Kennlinie ($I_L(U)$) verbunden ist, gegenüber der Rückelektrode des Schwingquarzes ein pyrometrischer Sensor zur Messung der mittleren Temperatur ($T_Q$) der Rückelektrode des Schwingquarzes angeordnet und der Schwingquarz mit seiner Frontelektrode und der pyrometrische Sensor einen Kombinationssensor bilden, der in dem Sensorgehäuse angeordnet ist, das eine der Frontelektrode des Schwingquarzes gegenüber liegende Öffnung aufweist, außerhalb des Sensorgehäuses zwischen dessen Öffnung und der Plasmaquelle in der Plasmaanlage eine schwenkbare Abschirmblende angeordnet ist, der Kombinationssensor verfahrbar ausgebildet und mit Mess- und Auswerteeinheiten und diese mit einem Rechner zur Datenaufnahme, - auswertung und -darstellung verbunden sind, wobei der Schwingquarz mit einer Messeinheit für die Bestimmung der Schwingquarzfrequenz ($f_Q$) und die planare Langmuir-Sonde mit einer Messeinheit für die Messung ihrer Strom-Spannungs-Kennlinie ($I_L(U)$) und der pyrometrische Sensor mit einem Messverstärker verbunden ist, und der Rechner aus diesen Messgrößen die Abscheide- bzw- Ätzrate (R(t)), die Plasmadichte ($n_e$ bzw. $n_i$), die Elektronentemperatur ($T_e$) und den totalen Energieeintrag ($E_{ein}$) des Plasmaprozesses ermittelt.

Durch die Modifizierung des Schwingquarzes, der gleichzeitig als planare Langmuir-Sonde und als Energiestrommesser benutzt werden kann, ist eine im Vergleich zum Stand der Technik kompaktere Ausbildung der Sensoranordnung möglich. Der erfindungsgemäße Sensor gestattet die simultane Erfassung von vier Messgrößen, wodurch eine schnellere Charakterisierung technologischer Plasmaprozesse ermöglicht wird.

In einer ersten Ausgestaltung ist vorgesehen, dass der pyrometrische Sensor einen gegen thermische Strahlung abgeschirmten Referenztemperatursensor aufweist.

Bei einer anderen Ausgestaltung ist die Rückelektrode des Schwingquarzes mit einer Schicht versehen, die eine hohe thermische Emissivität aufweist. Diese Schicht kann beispielsweise aus Ruß, einer nanostrukturierten MetallOxid-Mischschicht (Cermet), einer spektral selektiven Absorberschicht für Solarkollektoren oder einem vakuumtauglichen Thermolack bestehen.

Der Kombinationssensor ist in einer weiteren Ausgestaltung mit dem Sensorgehäuse thermisch verbunden und weist Mittel zur Kühlung auf, um Sensorgehäuse und Schwingquarz auf eine konstante Temperatur einzustellen.

Die Erfindung umfasst auch ein Verfahren zur Ermittlung von Kenngrößen von Plasmabeschichtungs- und Plasmaätzprozessen in einer Plasmaanlage für die Herstellung dünner Schichten unter Verwendung der beschriebenen erfindungsgemäßen Sensoranordnung, wobei das Verfahren die folgenden Verfahrensschritte umfasst: gleichzeitiges Messen der Resonanzfrequenz ($f_Q$) eines Schwingquarzes, der I-U-Kennlinie ($I_L(U)$) einer planaren Langmuir-Sonde sowie der mittleren Temperatur ($T_Q$) der Rückelektrode des Schwingquarzes an einer Position eines Kombinationssensors in der Plasmakammer mit einer Zeitauflösung im ms- bis s-Bereich, danach Übermitteln der gemessenen Daten ($f_Q$, $I_L(U)$ und $T_Q$) an einen Rechner zur Datenaufnahme, -auswertung und -darstellung, anschließend Berechnen des Verhältnisses von Ionenfluss zu Neutralteilchenfluss im Plasma während des Ätz- bzw. Beschichtungsprozesses sowie Bestimmen von Parametern des Plasmabeschichtungs- oder Plasmaätzprozesses wie Schichtdicke (d(t)) bzw. Abscheide- oder Ätzrate (R(t)), Plasmadichte ($n_e$ bzw. $n_i$), Elektronentemperatur ($T_e$) und Energieeinstrom ($E_{ein}$) aus den übermittelten Daten mittels eines Rechenprogramms, wobei bei der Bestimmung von Schichtdicke (d(t)) bzw. Abscheide- oder Ätzrate (R(t)) und Plasmadichte ($n_e$ bzw. $n_i$) sowie Elektronentemperatur ($T_e$) die geometrischen Abmessungen von Schwingquarz und Langmuir-Sonde berücksichtigt werden und bei der Bestimmung des totalen Energieeinstroms ($E_{ein}$) ein Energieeinstrom-Kalibrierfaktor berücksichtigt wird, wobei der Energieeinstrom-Kalibrierfaktor mittels einer kalibrierten Energiequelle, vorzugsweise eines Laserstrahls, vor dem Messen der mittleren Temperatur ($T_Q$) oder mittels Änderung der Energie von Ionen und Elektronen direkt aus dem Plasma bestimmt wird.

Der Energieeinstrom $E_{in}$ ist nach der Theorie des Gardon-Sensors (R. Gardon, Rev. Sci. Instr. 24/5 (1953) 366.) proportional zur mittleren Temperatur der dem Energiestrom ausgesetzten Membran, in unserem Fall der des Schwingquarzes:

$$E_{in} = c_{th} \cdot T_{mittel} \qquad (1),$$

wobei $c_{th}$ der Kalibrierfaktor ist (der in situ oder ex situ bestimmt werden kann, und $T_{mittel}$ ist die mit dem pyrometrischen Sensor gemessene Temperatur des Schwingquarzes.

Die Schichtdicke des Films $d_f$ (oder der Schichtabtrag) wird aus der Resonanzfrequenz $f_r$ des Schwingquarzes nach einer der bekannten Methode berechnet, siehe z.B. J. Appl. Phys 43 (1972) 4385. Umstellung von Gleichung (9) aus der Arbeit von Lu und Lewis ergibt für die Dicke des Films

$$d_f = \frac{\rho_q d_q}{\rho_f}\left(\frac{f_q}{f_f} - 1\right) \qquad (2),$$

wobei $r_q$ und $r_f$ die Dichte des Schwingquarzes und der Schicht sind, $d_q$ ist die Dicke des Quarzes und $f_q$ und $f_f$ sind die Resonanzfrequenzen des unbeschichteten und des beschichteten Schwingquarzes. Bei Verwendung eines kommerziellen Schwingquarzschichtdickenmessgerätes wird von diesem direkt die Schichtdicke (oder der Schichtabtrag) an das Auswerteprogramm übertragen. Die Analyse der gemessenen I-U-Kennlinien der planaren Langmuirsonde erfolgt durch die in der Literatur angegebenen Auswertealgorithmen, siehe z.B. Phys. Plasmas 14 (2007) 033507.

Das erwähnte Rechenprogramm kann gleichzeitig für die Ansteuerung der elektrischen oder der Gasversorgung der Plasmaquelle genutzt werden. So können systematische Abhängigkeiten (z. B. von der Entladungsleistung, der Substratvorspannung, dem Entladungsdruck oder von radialen oder axialen Profilen) schnell gemessen werden, wodurch eine umfassende und schnelle quantitative Analyse der Prozesscharakteristiken von Plasmaquellen ermöglicht wird.

In Ausgestaltung des Verfahrens ist vorgesehen, für Sensorgehäuse und Schwingquarz die gleiche Temperatur einzustellen. Eine andere Ausgestaltung des Verfahrens umfasst auch den Verfahrensschritt der Berechnung des Verhältnisses von Ionenfluss- zu Neutralteilchenfluss im Plasma während des Ätz-, Beschichtungs- bzw. Behandlungsprozesses.

Für die Bestimmung von räumlichen Profilen der zu ermittelnden Plasmaparameter wird der Kombinationssensor in verschiedene Messpositionen gefahren und die Messung an den einzelnen Komponenten des Kombinationssensors - der Resonanzfrequenz ($f_Q$) eines Schwingquarzes, der I-U-Kennlinie ($I_L(U)$) einer planaren Langmuir-Sonde sowie der mittleren Temperatur ($T_Q$) der Rückelektrode des Schwingquarzes - wiederholt.

Die Erfindung wird in folgendem Ausführungsbeispiel anhand von Figuren näher beschrieben.

Dabei zeigen die Figuren

Figur 1: schematisch den Schnitt durch einen erfindungsgemäßen Kombinationssensor;

Figur 2: das elektrische Blockschaltbild des Kombinationssensors mit Auswerteeinheiten und Rechner.

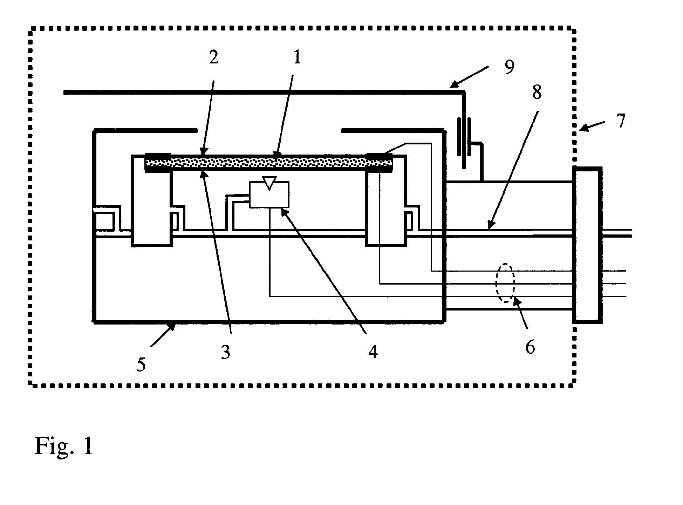

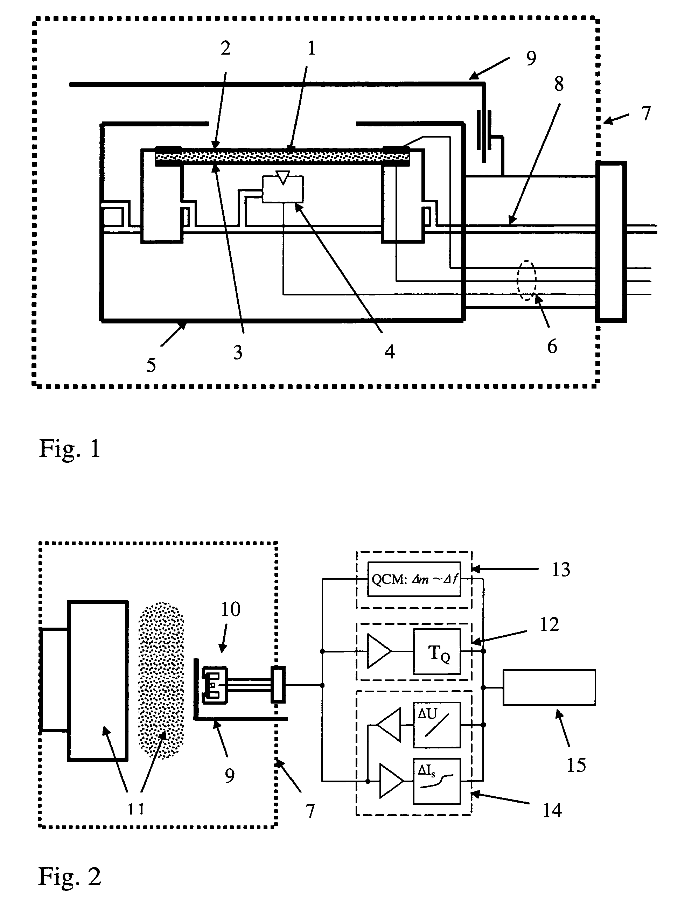

Der Kombinationssensor, dargestellt in Figur 1, ist in einer Vakuumapparatur **7** angeordnet und weist einen Schwingquarz **1** auf, dessen Frontelektrode **2** isoliert ist gegen das Sensorgehäuse **5**. Dadurch ist die Messung der Langmuir-Kennlinie möglich, da nun der elektrische Strom $I_Q$ auf diese dem Plasma ausgesetzte Elektrode als Funktion des Potentials $\Phi_Q$ relativ zum Plasmapotential $\Phi_P$ gemessen werden kann. Auf der Seite der Rückelektrode **3** des Schwingquarzes **1** ist ein pyrometrischer Sensor **4** angeordnet, der mit einem großen Öffnungswinkel - beispielsweise von ca. 64° - die mittlere Temperatur dieser Rückelektrode **3** misst. Die Kontaktfeder (nicht dargestellt) auf der Rückseite des Schwingquarzes **1** ist so konfiguriert, dass sie nicht das Gehäuse des pyrometrischen Sensors **4** kontaktiert und den optischen Strahlengang nicht einschränkt. Der pyrometrische Sensor **4** hat einen gegen thermische Strahlung abgeschirmten Referenztemperatursensor, so dass eine hohe Messgenauigkeit für die Temperatur des Schwingquarzes **1** möglich ist ($\Delta T < 0{,}02\,\text{K}$). Um das zu messende Infrarotsignal vom Schwingquarz **1** möglichst groß zu machen, kann die Rückelektrode **3** des Schwingquarzes **1** mit einer speziellen Schicht mit einer hohen thermischen Emissivität $\varepsilon$ beschichtet werden. Mittels einer Wasserkühlung **8** wird das Sensorgehäuse **5** gemeinsam mit dem Schwingquarz **1** auf konstanter Temperatur gehalten, um die thermische Drift der Schwingquarzfrequenz zu minimieren. Elektrische Zuleitungen **6** führen von den Komponenten des Kombisensors zu den entsprechenden Mess- und Auswerteeinheiten **12, 13, 14**. Die schwenkbare Blende **9** vor dem Kombinationssensor dient der Abschirmung des Sensors gegen das Plasma **11** (s. Fig. 2) und damit gegen Beschichtung bzw. Ätzabtrag. Damit ist eine Kontrolle des Nullsignals des Kombinationssensors in regelmäßigen Abständen möglich. Gleichzeitig wird die Dicke der wachsenden Schicht auf der Frontelektrode **2** begrenzt, so dass der Schwingquarz **1** für längere Messserien benutzt werden kann.

Nach der gleichzeitigen Messung der Resonanzfrequenz ($f_Q$) des Schwingquarzes **1**, der I-U-Kennlinie ($I_L(U)$) der aus der Frontelektrode **2** des Schwingquarzes **1** gebildeten planaren Langmuir-Sonde sowie der mittleren Temperatur ($T_Q$) der Rückelektrode **3** des Schwingquarzes **1** an einer Position des Kombinationssensors **10** im Plasmabereich **11** mit einer Zeitauflösung im ms- bis s-Bereich erfolgt die Datenauswertung. Dies ist schematisch in Figur 2 dargestellt. In einem Rechner **15** läuft ein Messprogramm ab, das die Daten von den Auswerteeinheiten für die Schwingquarzfrequenz **13,** für die Strom-Spannungs-Kennlinie **14** und vom Messverstärker **12** des pyrometrischen Sensors **4** übernimmt. Während in die Analyse von Abscheide-/Ätzrate bzw. der Plasmaparameter nur die geometrischen Abmessungen von Schwingquarz **1** und Langmuir-Elektrode **2** eingehen, ist für die Messung des totalen Energieeinstroms eine Kalibrierung notwendig. Die Kalibrierung wird mittels einer bekannten Energiequelle, z. B. eines aufgeweiteten Laserstrahls - wie in Surf. Coat. Techn. 116-119 (1999) 1102 beschrieben - durchgeführt, bevor der Kombinationssenor **10** in die Vakuumapparatur **7** eingesetzt wird. Bedingt durch die Beschichtung der Frontelektrode **2** des Schwingquarzes **1** während der Messungen, ändern sich die Sensoreigenschaften relativ schnell. Eine deshalb notwendige Kalibrierung kann direkt in der Plasmaapparatur erfolgen, indem die Energie von Ionen oder Elektronen aus dem Plasma variiert wird, indem gezielt eine negative oder positive Vorspannung an die Frontelektrode **2** des Schwingquarzes **1** angelegt wird. Dieses Kalibrierverfahren, bei dem sich der Energieeinstrom-Kalibrierfaktor in situ bestimmen lässt, ist in J. Appl. Phys. 82/5 (1997) 2115 beschrieben.

**Patentansprüche**

1. Sensoranordnung zur Charakterisierung von Plasmabeschichtungs- und Plasmaätzprozessen in einer Plasmaanlage, aufweisend einen Schwingquarz (1) mit einer Frontelektrode (2) und einer Rückelektrode (3),
   **dadurch gekennzeichnet, dass**

   - die dem Plasmaätz- oder Plasmabeschichtungsprozess ausgesetzte Frontelektrode (2) des Schwingquarzes (1) isoliert gegen ein Sensorgehäuse (5) der Anordnung und als planare Langmuir-Sonde ausgebildet und mit einem außerhalb der Plasmaanlage angeordneten Strom-Spannungs-Kennlinien-Messgerät (14) zur Messung der Langmuir-Kennlinie ($I_L(U)$) verbunden ist,

- gegenüber der Rückelektrode (3) des Schwingquarzes (1) ein pyrometrischer Sensor (4) zur Messung der mittleren Temperatur ($T_Q$) der Rückelektrode (3) des Schwingquarzes (1) angeordnet und

- der Schwingquarz (1) mit seiner Frontelektrode (2) und der pyrometrische Sensor (4) einen Kombinationssensor (10) bilden, der in dem Sensorgehäuse (5) angeordnet ist, das eine der Frontelektrode (2) des Schwingquarzes (1) gegenüber liegende Öffnung aufweist,

- außerhalb des Sensorgehäuses (5) zwischen dessen Öffnung und der Plasmaquelle in der Plasmaanlage eine schwenkbare Abschirmblende (9) angeordnet ist,

- der Kombinationssensor (10) verfahrbar ausgebildet und mit Mess-(12, 13, 14) und Auswerteeinheiten verbunden ist und diese mit einem Rechner (15) zur Datenaufnahme, -auswertung und -darstellung verbunden sind, wobei der Schwingquarz (1) mit einer Messeinheit (13) für die Bestimmung der Schwingquarzfrequenz ($f_Q$) und die planare Langmuir-Sonde (14) mit einer Messeinheit für die Messung ihrer Strom-Spannungs-Kennlinie ($I_L(U)$) und der pyrometrische Sensor (4) mit einem Messverstärker (12) verbunden ist, und

- der Rechner (15) mittels eines Messprogramms aus diesen Messgrößen die Abscheide - bzw. Ätzrate ($R(t)$), die Plasmadichte ($n_e$ bzw. $n_i$), die Elektronentemperatur ($T_e$) und den totalen Energieeintrag ($E_{ein}$) der Plasmaprozesse ermittelt.

2. Anordnung nach Anspruch 1,
   **dadurch gekennzeichnet, dass**
   der pyrometrische Sensor (4) einen gegen thermische Strahlung abgeschirmten Referenztemperatursensor aufweist.

3. Anordnung nach Anspruch 1,
   **dadurch gekennzeichnet, dass**
   die Rückelektrode (3) des Schwingquarzes (1) mit einer Schicht versehen ist, die eine hohe thermische Emissivität aufweist.

4. Anordnung nach Anspruch 1,
   **dadurch gekennzeichnet, dass**
   der Kombinationssensor (10) mit dem Sensorgehäuse (5) thermisch verbunden ist und Mittel zur Kühlung (8) aufweist und das Sensorgehäuse (5) mit dem Schwingquarz (1) auf eine konstante Temperatur eingestellt ist.

5. Verfahren zur Ermittlung von Kenngrößen von Plasmabeschichtungs- und Plasmaätzprozessen in einer Plasmaanlage für die Herstellung dünner Schichten unter Verwendung einer Sensoranordnung nach Anspruch 1, wobei das Verfahren die folgenden Verfahrensschritte umfasst:

   - gleichzeitiges Messen

     1. der Resonanzfrequenz ($f_Q$) eines Schwingquarzes,
     2. der I-U-Kennlinie ($I_L(U)$) einer planaren Langmuir-Sonde und
     3. der mittleren Temperatur ($T_Q$) der Rückelektrode des Schwingquarzes

   an einer Position eines Kombinationssensors in der Plasmakammer mit einer Zeitauflösung im ms- bis s-Bereich,

   - danach Übermitteln der gemessenen Daten ($f_Q$, $I_L(U)$ und $T_Q$) an einen Rechner zur Datenaufnahme, -auswertung und -darstellung und

   - Berechnen des Verhältnisses von Ionenfluss zu Neutralteilchenfluss im Plasma während des Ätz- bzw. Beschichtungsprozesses sowie

   - abschließendes Bestimmen der Parameter des Plasmabeschichtungs- oder Plasmaätzprozesses Schichtdicke ($d(t)$) bzw. Abscheide- oder Ätzrate ($R(t)$), Plasmadichte ($n_e$ bzw. $n_i$), Elektronentemperatur ($T_e$) und Energieeinstrom ($E_{ein}$) aus den übermittelten Daten mittels eines Rechenprogramms, wobei bei der Bestimmung von Schichtdicke ($d(t)$) bzw. Abscheide- oder Ätzrate ($R(t)$) und Plasmadichte ($n_e$ bzw. $n_i$) sowie Elektronentemperatur ($T_e$) die geometrischen Abmessungen von Schwingquarz und Langmuir-Sonde berücksichtigt werden und bei der Bestimmung des totalen Energieeinstroms ($E_{ein}$) ein Energieeinstrom-Kalibrierfaktor berücksichtigt wird, wobei dieser mittels einer kalibrierten Energiequelle, vorzugsweise eines Laserstrahls, vor dem Messen der mittleren Temperatur ($T_Q$) oder mittels Änderung der Energie von Ionen und Elektronen direkt aus dem Plasma bestimmt wird.

6. Verfahren nach Anspruch 5,
   **dadurch gekennzeichnet, dass**
   die gleiche Temperatur für Sensorgehäuse und Schwingquarz eingestellt wird.

7. Verfahren nach Anspruch 5,
   **dadurch gekennzeichnet, dass** ,
   der Kombinationssensor in verschiedene Messpositionen verfahren wird.

## Claims

1. Sensor arrangement for characterizing plasma coating and plasma etching processes in a plasma system, comprising a quartz crystal (1) with a front electrode (2) and a back electrode (3), **characterized in that**

   - the front electrode (2) of the quartz crystal (1) exposed to the plasma etching or plasma coating process is insulated against a sensor housing (5) of the arrangement and is configured as a planar Langmuir probe and is connected to a current-voltage characteristic curve measuring device (14) arranged outside the plasma system for measuring the Langmuir characteristic curve ($I_L(U)$),
   - a pyrometric sensor (4) for measurement of the mean temperature ($T_Q$) of the back electrode (3) of the quartz crystal (1) is arranged opposite the back electrode (3) of the quartz crystal (1) and
   - the quartz crystal (1) with the front electrode (2) and the pyrometric sensor (4) form a combination sensor (10) which is arranged in the sensor housing (5), which has an opening located opposite the front electrode (2) of the quartz crystal (1),
   - a pivotable screening diaphragm (9) is arranged outside the sensor housing (5) between the opening thereof and the plasma source in the plasma system,
   - the combination sensor (10) is configured to be movable and is connected to measurement (12, 13, 14) and evaluation units, and these are connected to a computer (15) for data acquisition, evaluation and display, wherein the quartz crystal (1) with a measuring unit (13) for determining the quartz crystal frequency ($f_Q$) and the planar Langmuir probe (14) is connected to a measuring unit for measuring its current-voltage characteristic curve ($I_L(U)$) and the pyrometric sensor (4) is connected to a measuring amplifier (12) and
   - the computer (15) determines the deposition or etching rate (R(t)), the plasma density (ne or $n_i$), the electron temperature ($T_e$) and the total energy input ($E_{ein}$) of the plasma processes, using a measurement program from these measured quantities.

2. The arrangement according to claim 1, **characterized in that** the pyrometric sensor (4) comprises a reference temperature sensor shielded from thermal radiation.

3. The arrangement according to claim 1, **characterized in that** the back electrode (3) of the quartz crystal (1) is provided with a layer which has a high thermal emissivity.

4. The arrangement according to claim 1, **characterized in that** the combination sensor (10) is thermally connected to the sensor housing (5) and has means for cooling (8) and the sensor housing (5) with the quartz crystal (1) is set to a constant temperature.

5. Method for determining the characteristics of plasma coating and plasma etching processes in a plasma system for producing thin layers using a sensor arrangement according to claim 1, wherein the method comprises the following process steps:

   - simultaneously measuring

     1. the resonant frequency ($f_Q$) of a quartz crystal,
     2. the I-U characteristic curve ($I_L(U)$) of a planar Langmuir probe, and
     3. the mean temperature ($T_Q$) of the rear electrode of the quartz crystal

   at a position of the combination sensor in the plasma chamber with a time resolution in the milliseconds to seconds range,
   - then transmitting the measured data ($f_Q$, $I_L(U)$ and $T_Q$) to the computer for data acquisition, evaluation and display, and
   - calculating the ratio of ion flux to neutral particle flux in the plasma during the etching or coating processes and
   - finally determining the parameters of the plasma coating or plasma etching process such as layer thickness (d(t)) or deposition or etch rate (R(t)), plasma density (ne or $n_i$), electron temperature ($T_e$) and energy influx ($E_{ein}$) from the transmitted data by means of a computer program, wherein the geometrical dimensions of quartz crystal and Langmuir probe are taken into account during the determination of layer thickness (d(t)) or deposition or etch rate (R(t)) and plasma density ($n_e$ or $n_i$) as well as electron temperature ($T_e$) and an energy influx calibration factor is taken into account during the determination of total energy influx ($E_{ein}$), wherein this is determined by means of a calibrated energy source, preferably a laser beam, before measurement of the mean temperature ($T_Q$) or by means of variation of the energy of ions and electrons directly from the plasma.

6. The method according to claim 5, **characterized in that** the same temperature is set for sensor housing and quartz crystal.

7. The method according to claim 5, **characterized in**

**that** the combination sensor is moved into different measuring positions.

**Revendications**

1. Dispositif de capteur pour la caractérisation de processus de revêtement plasma et de gravure plasma dans une installation plasma, présentant un quartz oscillant (1) avec une électrode avant (2) et une électrode arrière (3), **caractérisé en ce que**

   - l'électrode avant (2) du quartz oscillant (1) exposée au processus de revêtement plasma ou de gravure plasma est conçue de manière isolée contre un logement de capteur (5) du dispositif et comme sonde de Langmuir planaire et est relié avec un appareil de mesure (14) de courbe caractéristique courant-tension disposé à l'extérieur de l'installation plasma pour mesurer la courbe caractéristique de Langmuir ($I_L(U)$),
   - en vis-à-vis de l'électrode arrière (3) du quartz oscillant (1) est disposé un capteur pyrométrique (4) pour mesurer la température moyenne ($T_Q$) de l'électrode arrière(3) du quartz oscillant (1),
   - le quartz oscillant (1) avec son électrode avant (2) et le capteur pyrométrique (4) forment un capteur de combinaison (10), qui est disposé dans le logement de capteur (5), qui présente une ouverture située en vis-à-vis d'une des électrodes avant (2) du quartz oscillant (1),
   - à l'extérieur du logement de capteur (5) entre son ouverture et la source plasma un écran de protection (9) pivotant est disposé dans l'installation plasma,
   - un capteur de combinaison (10) est conçu de manière déplaçable et est relié avec des unités de mesure (12, 13, 14) et d'évaluation et celles-ci sont reliées avec un ordinateur (15) à des fins d'acquisition, évaluation et représentation des données, dans lequel le quartz oscillant (1) est relié avec une unité de mesure (13) pour déterminer la fréquence de quartz oscillant ($f_Q$) et la sonde Langmuir planaire (14) est reliée avec une unité de mesure pour la mesure de sa courbe caractéristique courant-tension ($I_L(U)$) et le capteur pyrométrique (4) est relié avec un amplificateur de mesure (12) et
   - l'ordinateur (15) détermine au moyen d'un programme de mesure d'après ces grandes de mesure les taux de séparation respectivement de gravure (R(t)), la densité du plasma (ne resp. $n_i$), la température d'électrons ($T_e$) et l'apport d'énergie total ($E_{ein}$) du processus plasma.

2. Dispositif selon la revendication 1, **caractérisé en ce que** le capteur pyrométrique (4) présente un capteur de température de référence blindé contre un rayonnement thermique.

3. Dispositif selon la revendication 1, **caractérisé en ce que** l'électrode arrière (3) du quartz oscillant (1) est pourvue d'une couche, qui présente une haute émissivité thermique.

4. Dispositif selon la revendication 1, **caractérisé en ce que** le capteur de combinaison (10) est relié thermiquement avec le logement de capteur (5) et présente des moyens de refroidissement (8) et le logement de capteur (5) est réglé avec le quartz oscillant (1) sur une température constante.

5. Procédé de détermination de grandeurs caractéristiques de processus de revêtement plasma et de gravure plasma dans une installation plasma à couches minces en utilisant un dispositif de capteur selon la revendication 1, dans lequel le procédé comprend les étapes de procédé suivantes :

   - mesure simultanée de

      1. la fréquence de résonance ($f_Q$) d'un quartz oscillant,
      2. la courbe caractéristique I-U ($I_L(U)$) d'une sonde Langmuir planaire et
      3. la température moyenne ($T_Q$) de l'électrode arrière du quartz oscillant,

   sur une position d'un capteur de combinaison dans la chambre plasma avec une résolution temporelle dans la plage milliseconde à seconde,
   - détermination consécutive des données mesurées ($f_Q$, $I_L(U)$ et $T_Q$) sur un ordinateur à des fins d'acquisition, évaluation et représentation des données et
   - calcul du rapport du flux d'ions sur le flux de particules neutres dans le plasma pendant le processus de revêtement, respectivement de gravure ainsi que
   - détermination finale des paramètres du processus de revêtement plasma ou de gravure plasma épaisseur de couche (d(t)) respectivement taux de séparation ou de gravure (R(t)), densité du plasma ($n_e$ resp. $n_i$), température d'électrons ($T_e$) et courant d'apport d'énergie ($E_{ein}$) d'après les données déterminées au moyen d'un programme informatique, dans lequel lors de la détermination de l'épaisseur de couche (d(t)) respectivement taux de séparation ou de gravure (R(t)), densité du plasma ($n_e$ resp. $n_i$), ainsi que température d'électrons ($T_e$) les dimensions géométriques du quartz oscillant et de la sonde Langmuir sont prises en compte et lors de la détermination du courant d'apport

d'énergie total ($E_{ein}$) un facteur de calibrage de courant d'apport d'énergie est pris en compte, dans lequel celui-ci est déterminé au moyen d'une source d'énergie calibrée, de préférence d'un rayon laser, avant la mesure de la température moyenne ($T_Q$) ou au moyen de la variation d'énergie des ions et électrons provenant directement du plasma.

6. Procédé selon la revendication 5, **caractérisé en ce que** la même température est réglée pour le logement de capteur et le quartz oscillant.

7. Procédé selon la revendication 5, **caractérisé en ce que** le capteur de combinaison est déplacé dans différentes positions de mesure.

Fig. 1

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2005034811 A1
- US 5885402 A

**In der Beschreibung aufgeführte Nicht-Patentliteratur**

- Applications of Piezoelectric Quartz Crystal Microbalances. Elsevier, 1984, 221
- Plasma Diagnostics. Academic Press, 1989, 113
- *J. Vac. Sci. Techn.,* 1978, vol. 15 (2), 188
- *Rev. Sci. Instr.,* 2010, vol. 10, 023504
- *Veröffentlichung Rev. Sci. Instr.,* 1997, vol. 68, 4555
- *Rev. Sci. Instr.,* 1999, vol. 70, 3696
- *J. Vac. Sci.Techn. A,* 1990, vol. 8, 3920
- *Surf. Coat. Techn.,* 1995, vol. 74/75, 586
- *Thin Solid Films,* 2009, vol. 517, 3143
- s. Thin Films/11th Conf. On High Vacuum, Interfaces and Thin Films. *DGM Informationsgesellschaft mbH, Oberursel, Dresden,* Marz 1994, 131
- *Surf.Coat. techn.,* 1999, vol. 116-119, 1102
- *J. Appl. Phys.,* 1997, vol. 82 (5), 2115
- **K. ELLMER ; R. MIENTUS.** *Surf. Coat. Techn.,* 1999, vol. 116-119, 1102
- **VON K. HARBAUER.** FB Physikalische Technik. *Techn. Fachhochschule Wildau,* 2005
- **R. GARDON.** *Rev. Sci. Instr.,* 1953, vol. 24 (5), 366
- *J. Appl. Phys,* 1972, vol. 43, 4385
- *Phys. Plasmas,* 2007, vol. 14, 033507
- *Surf. Coat. Techn.,* 1999, vol. 116-119, 1102